# EUROPEAN PATENT APPLICATION

(11) **EP 4 583 652 A1**
(43) Date of publication of application: **09.07.2025**
(21) Application number: 25150577.2
(22) Date of filing: 07.01.2025
(51) Int. Cl.: H05K 7/20

(54) **CABINET, ENERGY STORAGE CONVERTER, ENERGY STORAGE SYSTEM, AND PHOTOVOLTAIC POWER GENERATION SYSTEM**

(30) Priority: 08.01.2024 CN 202420046512 U
(71) Applicant: Sungrow Power Supply Co., Ltd., Hefei, Anhui 230088 (CN)
(72) Inventor: ZHANG, Hao, Hefei, 230088 (CN); ZHOU, Huan, Hefei, 230088 (CN); YAN, Longxiang, Hefei, 230088 (CN)
(74) Representative: DREISS Patentanwälte PartG mbB

(57) **Abstract**

The present disclosure discloses a cabinet, an energy storage converter, an energy storage system, and a photovoltaic power generation system. The cabinet includes a cabinet body, a liquid-cooling heat exchanger, a cooling fin, and a heat dissipation fan. An end chamber, a direct ventilation cavity, and an electronic cavity are formed in the cabinet body. The electronic cavity is a closed cavity. Part of a direct ventilation duct is formed in the direct ventilation cavity. Two ends of the direct ventilation duct are in communication with an outside world. The liquid-cooling heat exchanger is disposed in the electronic cavity. The cooling fin is disposed in the end chamber. The liquid-cooling heat exchanger is connected to the cooling fin through a first pipeline, and the first pipeline contains a cooling liquid. The heat dissipation fan is configured to guide an external airflow to flow into the end chamber, flow through the cooling fin, and flow out of the cabinet body. With the cabinet according to the present disclosure, heat dissipation is performed for the direct ventilation cavity and the electronic cavity through the liquid-cooling heat exchanger. The direct ventilation duct is used to strengthen heat dissipation of the cabinet. The closed electronic cavity is provided, which takes into account the heat dissipation effect when a protection effect of the cabinet is improved.

## Description

### FIELD

The present disclosure relates to the technical field of energy storage devices, and in particular to a cabinet, an energy storage converter, an energy storage system, and a photovoltaic power generation system.

### BACKGROUND

As a pivotal power conversion device in an energy storage system, an energy storage converter plays a role of alternating current and direct current conversion. With enhancement in the capacity of an energy storage battery and improvement of the integration degree inside the energy storage converter, the whole machine power density continuously increases. However, air-cooling is widely used currently for heat dissipation, which cannot effectively protect electronic components in the device while dissipating a large amount of heat.

Therefore, there is a need for improving the energy storage converter.

### SUMMARY

The present disclosure aims to at least solve one of the technical problems in the related art to some extent. To this end, the present disclosure proposes a cabinet for an energy storage converter, which performs heat dissipation for the cabinet through a liquid-cooling heat exchanger and also achieves an anti-pollution effect for components in the device.

The cabinet for the energy storage converter according to the present disclosure includes a cabinet body, a liquid-cooling heat exchanger, a cooling fin, and a heat dissipation fan. The cabinet body includes an end chamber, a direct ventilation cavity, and an electronic cavity. The direct ventilation cavity is independent from the electronic cavity. The electronic cavity is independent from the end chamber. At least part of a direct ventilation duct is formed in the direct ventilation cavity, and two ends of the direct ventilation duct are in communication with outside of the cabinet body. The liquid-cooling heat exchanger is disposed in the electronic cavity. The cooling fin is disposed in the end chamber. The liquid-cooling heat exchanger is connected to the cooling fin through a first pipeline, and the first pipeline contains a cooling liquid. The heat dissipation fan is configured to guide an external airflow to flow into the end chamber and flow out of the cabinet body after flowing through the cooling fin.

With the cabinet for the energy storage converter according to the present disclosure, the direct ventilation cavity and the electronic cavity are provided. The electronic cavity is independent relative to the direct ventilation cavity. When a temperature of the electronic cavity is higher than that of the direct ventilation cavity, heat exchange may occur between the electronic cavity and the direct ventilation cavity, to transfer superfluous heat in the electronic cavity to the direct ventilation cavity. In addition, the direct ventilation duct is formed in the direct ventilation cavity. The direct ventilation duct has two ends in communication with an outside world, i.e., both heat transferred from the electronic cavity and heat generated by components in the cavity itself can be transferred to the outside of the cabinet body. For the relatively independent electronic cavity, the liquid-cooling heat exchanger serves as first heat dissipation, and heat exchange with the direct ventilation cavity forms second heat dissipation, which improves the heat dissipation effect of the electronic cavity while improving a protection effect of the electronic cavity.

According to some embodiments of the present disclosure, the cabinet body further includes a power module disposed in the direct ventilation cavity. The power module includes a liquid-cooling heat exchange unit. The liquid-cooling heat exchange unit is connected to the cooling fin through a second pipeline, and the second pipeline contains a cooling liquid.

According to some embodiments of the present disclosure, the cabinet body has a heat dissipation air inlet and a heat dissipation air outlet. The end chamber is in communication with the outside of the cabinet body through the heat dissipation air inlet and the heat dissipation air outlet, and the heat dissipation fan is disposed in the end chamber.

According to some embodiments of the present disclosure, the cabinet body has a heat dissipation air inlet and a direct ventilation outlet. The end chamber is in communication with the outside of the cabinet body through the heat dissipation air inlet. The direct ventilation cavity is in communication with the outside of the cabinet body through the direct ventilation outlet. The end chamber is in communication with the direct ventilation cavity to form the direct ventilation duct, and the heat dissipation fan is disposed in the end chamber and/or the direct ventilation cavity.

According to some embodiments of the present disclosure, an outer wall of the direct ventilation cavity has a direct ventilation inlet and a direct ventilation outlet. The direct ventilation cavity is in communication with the outside of the cabinet body through each of the direct ventilation inlet and the direct ventilation outlet, and at least one direct ventilation fan is provided in the direct ventilation cavity.

According to some embodiments of the present disclosure, at least one circulating fan is provided in the electronic cavity. The at least one circulating fan is configured to drive an airflow in the electronic cavity to flow.

According to some embodiments of the present disclosure, the electronic cavity includes a first electronic sub-chamber, a second electronic sub-chamber, and a connection chamber, the first electronic sub-chamber being in in communication with the second electronic sub-chamber through the connection chamber. The first electronic sub-chamber and the second electronic sub-chamber are located on two sides of the direct ventilation cavity, and the connection chamber extends through the direct ventilation cavity.

In an embodiment, a circulating fan is provided in each of the first electronic sub-chamber and the second electronic sub-chamber. The circulating fan is configured to drive an airflow in the first electronic sub-chamber, the connection chamber, and the second electronic sub-chamber to flow in a predetermined direction.

According to some embodiments of the present disclosure, the liquid-cooling heat exchanger has a first heat exchange channel and a second heat exchange channel. The first heat exchange channel is connected to the cooling fin through the first pipeline, and the electronic cavity is in communication with the second heat exchange channel to exchange heat with the first heat exchange channel.

According to an embodiment of another aspect of the present disclosure, an energy storage converter is provided, which includes a cabinet, a first component, and a second component. The cabinet is the cabinet for the energy storage converter in the above-described embodiments. The first component is disposed in the direct ventilation cavity. The second component is disposed in the electronic cavity. The cabinet has the same advantages as the above-described cabinet for the energy storage converter compared with the prior art, , which are not repeated here.

According to an embodiment of another aspect of the present disclosure, an energy storage system is provided, which includes the energy storage converter in the above embodiments.

According to an embodiment of another aspect of the present disclosure, a photovoltaic power generation system is provided, which includes the energy storage system in the above embodiments.

Additional aspects and advantages of the present disclosure will be provided in part in the following description, or will become apparent in part from the following description, or can be learned from practicing of the present disclosure.

### BRIEF DESCRIPTION OF THE DRAWINGS

FIG. 1 is a schematic structural diagram of a cabinet according to an embodiment of the present disclosure.
FIG. 2 is a schematic structural diagram of a cabinet according to another embodiment of the present disclosure.
FIG. 3 is a schematic structural diagram of a cabinet according to another embodiment of the present disclosure.
FIG. 4 is a schematic structural diagram of a cabinet according to another embodiment of the present disclosure.
FIG. 5 is a schematic structural diagram of a cabinet according to another embodiment of the present disclosure.
FIG. 6 is a schematic structural diagram of a cabinet according to another embodiment of the present disclosure.

### Reference numerals:

cabinet 1000;
cabinet body 100;
end chamber 200, heat dissipation air inlet 201, heat dissipation air outlet 202;
direct ventilation cavity 300, power module 310, liquid-cooling heat exchange unit 320, direct ventilation fan 330, direct ventilation duct 400, direct ventilation inlet 410, direct ventilation outlet 420;
electronic cavity 500, first electronic sub-chamber 510, second electronic sub-chamber 520, connection chamber 530;
liquid-cooling heat exchanger 600, first pipeline 601, second pipeline 602, first heat exchange channel 603, second heat exchange channel 604;
cooling fin 700, heat dissipation fan 800, and circulating fan 900.

### DETAILED DESCRIPTION

Embodiments of the present disclosure will be described in detail below with reference to examples thereof as illustrated in the accompanying drawings, throughout which same or similar elements, or elements having same or similar functions, are denoted by same or similar reference numerals. The embodiments described below with reference to the drawings are illustrative merely, and are intended to explain, rather than limiting, the present disclosure.

In the description of the embodiments of the present disclosure, the terms "first" and "second" are only used for description purposes, and cannot be understood as indicating or implying relative importance or implying the number of indicated technical features. Therefore, the features associated with "first" and "second" may explicitly or implicitly include at least one of the features. In the description of the present disclosure, "a plurality of' means two or more than two, unless specified otherwise.

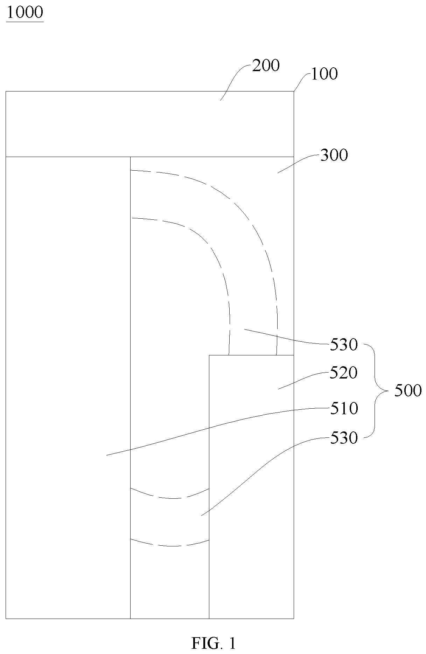

A cabinet 1000 for an energy storage converter according to the embodiments of the present disclosure is described in detail with reference to FIG. 1 to FIG. 6.

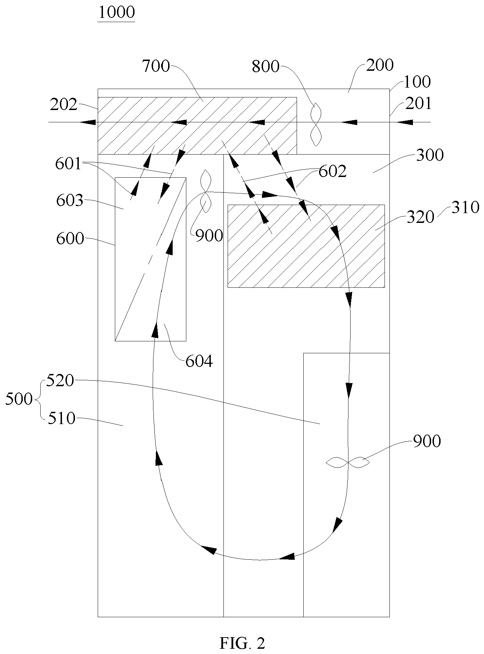

Referring to FIG. 2, FIG. 4, and FIG. 6, the cabinet 1000 includes a cabinet body 100, a liquid-cooling heat exchanger 600, a cooling fin 700, and a heat dissipation fan 800.

An end chamber 200, a direct ventilation cavity 300, and an electronic cavity 500 are formed in the cabinet 1000. The end chamber 200 is located at a same end of the direct ventilation cavity 300 and the electronic cavity 500. For example, in FIG. 1 to FIG. 6, the end chamber 200 is located at a top end of the direct ventilation cavity 300 and a top end of the electronic cavity 500. In some embodiments not shown in the drawings, the end chamber 200 may be located at a bottom end or a side end of the direct ventilation cavity 300 and the electronic cavity 500. The direct ventilation cavity 300 is independent from the electronic cavity 500. The electronic cavity 500 is independent from the end chamber 200. The electronic cavity 500 is completely closed, which ensures that an environment inside the electronic cavity 500 is relatively stable and pollution-free. Meanwhile, the electronic cavity 500 forms a closed annular shape, and an airflow may circularly flow in the electronic cavity 500 along a predetermined direction. The predetermined direction refers to a direction of a loop along an interior of the electronic cavity 500. The direct ventilation cavity 300 forms at least part of a direct ventilation duct 400. Two ends of the direct ventilation duct 400 are in communication with outside of the cabinet body 100, respectively. When an outside air passes through the direct ventilation duct 400, superfluous heat in the direct ventilation cavity 300 is taken away and is guided to the outside, to complete heat dissipation of the direct ventilation cavity 300.

It should be understood that when there is a temperature difference between the direct ventilation cavity 300 and the electronic cavity 500, heat transfer occurs between the electronic cavity 500 and the direct ventilation duct 400. Specifically, heat transfers from a heat source cavity having a higher temperature to a cavity having a lower temperature through a side wall at which the two cavities are in contact with each other, to realize heat exchange. For example, the direct ventilation cavity 300 occupies a side of the cabinet 1000. The direct ventilation duct 400 extends in a vertical direction in the cabinet 1000. The electronic cavity 500 is a closed annular cavity. The direct ventilation duct 400 passes through the electronic cavity 500, and the electronic cavity 500 is independent of the direct ventilation duct 400. The direct ventilation duct 400 passes through the electronic cavity 500 at least once. In an embodiment, the direct ventilation duct 400 may alternatively pass through the electronic cavity 500 one or multiple times. In the embodiment, only a case where the direct ventilation duct 400 passes through the electronic cavity 500 twice is described. Since the direct ventilation duct 400 has circulation of a straight-through air, a temperature of the direct ventilation cavity 300 is made lower than a temperature of the electronic cavity 500. The electronic cavity 500 transfers superfluous heat to the direct ventilation cavity 300 through heat exchange. The superfluous heat of the direct ventilation cavity 300 may be further carried to the outside of the cabinet body 100 by the straight-through airflow in the direct ventilation duct 400, thereby dissipating the heat in the electronic cavity 500. Therefore, when the direct ventilation duct 400 passes through the electronic cavity 500 twice, the heat dissipation effect occurs twice.

In an embodiment, a liquid-cooling heat exchanger 600 is provided in the electronic cavity 500. The liquid-cooling heat exchanger 600 has a first pipeline 601. The first pipeline 601 contains a cooling liquid. An airflow in the electronic cavity 500 flows into the liquid-cooling heat exchanger 600 to exchange heat with the cooling liquid in the liquid-cooling heat exchanger 600 and the first pipeline 601. A low-temperature airflow after the heat exchange flows into the electronic cavity 500 to reduce the temperature of the electronic cavity 500. In this way, the electronic cavity 500 dissipates heat through not only the direct ventilation duct 400, but also the liquid-cooling heat exchanger 600 which further strengthens the heat exchange effect and improves the heat exchange efficiency of the electronic cavity 500. Further, the liquid-cooling heat exchanger 600 implements heat transfer by utilizing the cooling liquid which has a greater heat capacity than air, and absorbs more heat than air under the same temperature change, ensuring high heat dissipation efficiency, such that the electronic cavity 500 can be maintained at a stable temperature. Therefore, the temperature in the electronic cavity 500 can be effectively reduced. Such efficient heat reduction facilitates dense deployment of components in the electronic cavity 500 and improves an integration degree of the components. Meanwhile, the liquid-cooling heat exchanger 600 has relatively low noise, which is beneficial to keeping the cabinet 1000 relatively silent. The liquid-cooling heat exchanger 600 is connected to the cooling fin 700 by using the first pipeline 601. Therefore, there is no need to consider an arrangement of a heat exchange duct as an air-cooling heat dissipation component, making a layout of the liquid-cooling heat exchanger 600 in the cabinet 1000 more flexible, which is beneficial to improving the utilization rate of the internal space of the cabinet body 100.

The cooling fin 700 is disposed in the end chamber 200. The first pipeline 601 in the liquid-cooling heat exchanger 600 is connected to the cooling fin 700. The cooling liquid in the liquid-cooling heat exchanger 600 and the first pipeline 601 absorbs heat from the electronic cavity 500 and then flows to the cooling fin 700, which absorbs and dissipates the superfluous heat, causing the cooling liquid to cool down. After cooling, the cooling liquid continues to circulate into the liquid-cooling heat exchanger 600 for continuously performing heat absorption and dissipation, to stabilize the temperature in the electronic cavity 500.

In addition, a heat dissipation fan 800 is further provided in the end chamber 200. The heat dissipation fan 800 is configured to guide an external airflow to flow into the end chamber 200 and flow out of the cabinet body 100 after flowing through the cooling fin 700, to dissipate the heat absorbed by the cooling fin 700 to the outside, thereby completing the heat dissipation. In the related art, performing heat dissipation on the cavity by using air cooling requires a fan with a large power. In contrast, in the embodiments of the present disclosure, heat dissipation for the electronic cavity 500 mainly relies on liquid cooling, which is beneficial to reducing the power of the heat dissipation fan 800, thereby reducing the cost of the fan. Meanwhile, a fan with a small power generates small noise, so that noise of the cabinet 1000 during operation is small.

In the related art, all internal cavities of the cabinet are fully closed cavities, and exchange heat with the outside world through the heat exchanger. This heat dissipation method cannot meet heat dissipation requirements of a component with a large heat productivity inside the cavity, increasing the risk of component damage. In the embodiments of the present disclosure, the direct ventilation cavity 300 is provided, and the component with a large heat productivity may be arranged in the direct ventilation cavity 300. The heat produced by the component may be brought to the outside world by the straight-through airflow in the direct ventilation duct 400 to realize heat dissipation, which improves the heat dissipation effect. The straight-through airflow in the direct ventilation duct 400 does not interfere with the heat dissipation of the electronic cavity 500 through the liquid-cooling heat exchanger 600.

With the cabinet 1000 for an energy storage converter according to the present disclosure, the relatively independent electronic cavity 500 is provided, important components are arranged in the electronic cavity 500 for independent protection, which ensures a dustproof effect and a waterproof effect for the components in the electronic cavity 500, and improves a protection level. The direct ventilation cavity 300 and the direct ventilation duct 400 are further provided. Heat in the direct ventilation cavity 300 and the electronic cavity 500 is taken away by utilizing the direct ventilation duct 400 to ensure the heat dissipation effect of the whole machine. Further, the liquid-cooling heat exchanger 600 is provided in the electronic cavity 500 to make the electronic cavity 500 have double heat dissipation abilities, thereby ensuring stable operation of the components in the electronic cavity 500. As a result, the cabinet 1000 has both a heat dissipation function and a protection function.

Referring to FIG. 2, the cabinet 1000 according to some embodiments of the present disclosure further includes a power module 310 provided in the cabinet body 100. The power module 310 is disposed in the direct ventilation cavity 300. This is because the power module 310 has large heat productivity. When the power module 310 is arranged in the direct ventilation cavity 300, heat generated by the power module 310 can be transferred to outside of the cabinet 1000 through the direct ventilation duct 400, thereby reducing the heat dissipation pressure of the whole machine and maintaining the operation environment of the cabinet 1000.

In an embodiment, the power module 310 includes a liquid-cooling heat exchange unit 320. The liquid-cooling heat exchange unit 320 absorbs part of the heat generated by the power module 310, to keep a temperature of the component in the direct ventilation cavity 300 stable, thereby avoiding a rapid temperature rise when the cabinet 1000 is in operation. Meanwhile, the heat dissipation pressure on the direct ventilation duct 400 is reduced, and the heat dissipation ability of the direct ventilation duct 400 for the electronic cavity 500 is indirectly improved, which is beneficial to improving the heat dissipation efficiency of the whole machine.

The liquid-cooling heat exchange unit 320 is connected to the cooling fin 700 through a second pipeline 602, and the second pipeline 602 contains a cooling liquid. The cooling liquid absorbs heat of the power module 310, and the absorbed heat is transferred to the cooling fin 700 via the second pipeline 602, thereby reducing the heat of the power module 310. The first pipeline 601 and the second pipeline 602 may share a set of cooling fin 700, which is beneficial to mounting and layout of the cooling fin 700 in the end chamber 200, or the first pipeline 601 and the second pipeline 602 may use two sets of cooling fin 700, separately, which can enhance the heat dissipation effect. For convenience of description, in the present disclosure, as an example, the first pipeline 601 and the second pipeline 602 share a set of cooling fin 700.

By integrating the liquid-cooling heat exchange unit 320 into the power module 310, space occupation in the direct ventilation cavity 300 is reduced, which facilitates space utilization and planning, such that components other than the power module 310 can be provided in the direct ventilation cavity 300, or a volume of the cabinet 1000 can be reduced, thereby improving flexibility of application of the cabinet 1000 and increasing application scenarios of the cabinet 1000. In other embodiments not shown in the drawings, the power module 310 and the liquid-cooling heat exchange unit 320 are separately disposed in the direct ventilation cavity 300, which is beneficial to later maintenance. When one of components of the power module 310 and the liquid-cooling heat exchange unit 320 needs to be repaired or even replaced, the component may be operated separately, thereby reducing maintenance and replacement costs.

In the cabinet 1000 according to some embodiments of the present disclosure, referring to FIG. 2 to FIG. 4, the cabinet body 100 has a heat dissipation air inlet 201 and a heat dissipation air outlet 202. The end chamber 200 is in communication with the outside of the cabinet body 100 through the heat dissipation air inlet 201 and the heat dissipation air outlet 202. The outside air enters the end chamber 200 through the heat dissipation air inlet 201, takes away superfluous heat of the cooling fin 700, and flows out of the cabinet body 100 through the heat dissipation air outlet 202. It is known that the air is sucked in through the heat dissipation air inlet 201 and passes through the cooling fin 700, and then the heated air is discharged from the cabinet 1000 through the heat dissipation air outlet 202. Therefore, the heat dissipation air inlet 201 and the heat dissipation air outlet 202 may be provided at a top or a side surface of the end chamber 200. In this embodiment, the heat dissipation air inlet 201 and the heat dissipation air outlet 202 are provided at the side surface of the cabinet body 100.

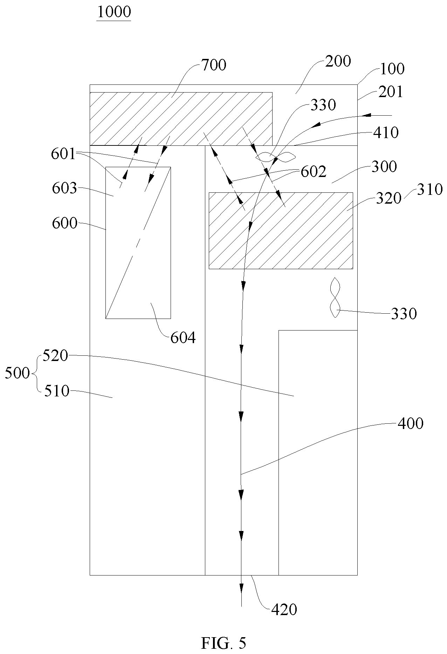

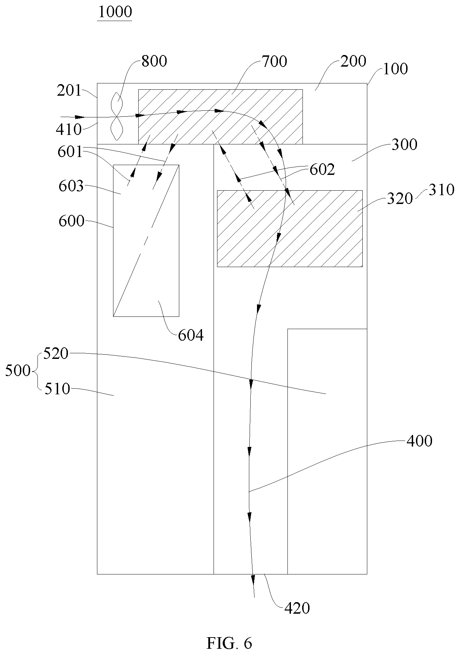

In the cabinet 1000 according to some embodiments of the present disclosure, referring to FIG. 5 and FIG. 6, the cabinet body 100 has a heat dissipation air inlet 201 and a direct ventilation outlet 420. The end chamber 200 is in communication with the outside of the cabinet body 100 through the heat dissipation air inlet 201. The direct ventilation cavity 300 is in communication with the outside of the cabinet body 100 through the direct ventilation outlet 420. The end chamber 200 is in communication with the direct ventilation cavity 300 to form the direct ventilation duct 400. It is known that the air is sucked in through the heat dissipation air inlet 201, and then the heated air is discharged from the cabinet 1000 through the direct ventilation outlet 420. Therefore, the heat dissipation air inlet 201 may be provided at the top or the side surface of the end chamber 200. The direct ventilation outlet 420 may be provided at a bottom or a side surface of the direct ventilation cavity 300. In this embodiment, the heat dissipation air inlet 201 is disposed at the side surface of the end chamber 200, and the direct ventilation outlet 420 is disposed at the bottom of the direct ventilation cavity 300.

In an embodiment, a filter mesh may be provided at the heat dissipation air inlet 201 to filter out dust and impurities in the air, to prevent entry of foreign matters into the cabinet 1000 from affecting the operation of the cabinet 1000.

Referring to FIG. 2, FIG. 4, and FIG. 6, the heat dissipation fan 800 is provided in the end chamber 200, for increasing a speed of air sucked in or discharged from the end chamber 200, to rapidly reduce the temperature of the cooling fin 700. Of course, the heat dissipation fan 800 includes, but is not limited to, a blowing fan, an exhaust fan, and the like. The heat dissipation fan 800 functions to guide circulation between the air in the end chamber 200 and the outside air.

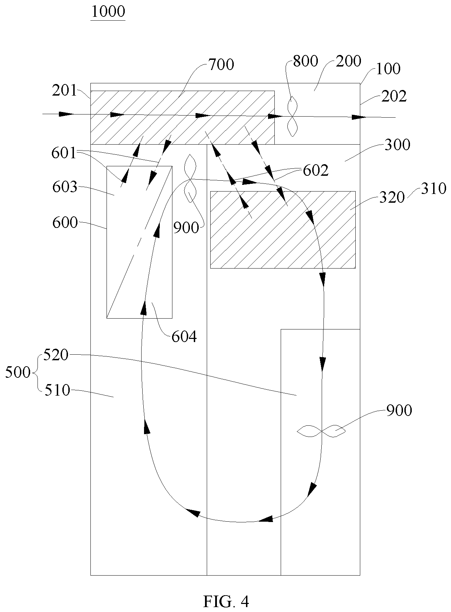

In an embodiment, the heat dissipation fan 800 is disposed on at least one side of the cooling fin 700. For example, the heat dissipation fan 800 may be disposed at the heat dissipation air inlet 201 or the heat dissipation air outlet 202. Alternatively, each of the heat dissipation air inlet 201 and the heat dissipation air outlet 202 is provided with the heat dissipation fan 800. Referring to FIG. 4, the heat dissipation fan 800 is provided at the same side of the cooling fin 700 as the heat dissipation air outlet 202, i.e., the right side of the cooling fin 700, such that an airflow flowing through the cooling fin 700 is diffused, and the diffused airflow enters the heat dissipation fan 800, generating less noise. Referring to FIG. 2 and FIG. 6, the heat dissipation fan 800 is provided at the same side of the cooling fin 700 as the heat dissipation air inlet 201, i.e., the left side of the cooling fin 700, such that the air sucked in directly enters the cooling fin 700, increasing the speed of the air entering the cooling fin 700, and providing a better heat dissipation airflow, thereby effectively discharging heat from the cabinet 1000.

In an embodiment, the heat dissipation fan 800 may alternatively be disposed in the direct ventilation cavity 300, to increase the air inlet volume of the direct ventilation duct 400, which improves the heat exchange ability of the direct ventilation duct 400, and further ensures the heat exchange effect of the cabinet 1000.

In an embodiment, each of the end chamber 200 and the direct ventilation cavity 300 is provided with the heat dissipation fan 800 to further enhance the heat dissipation effect of the cabinet 1000.

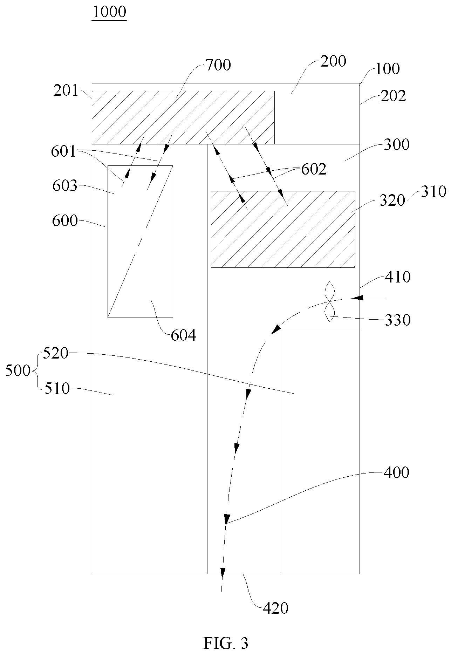

In an embodiment, referring to FIG. 3, an outer wall of the direct ventilation cavity 300 has a direct ventilation inlet 410 and a direct ventilation outlet 420. The direct ventilation cavity 300 is in communication with the outside of the cabinet body 100 through the direct ventilation inlet 410 and the direct ventilation outlet 420. At least one direct ventilation fan 330 is provided in the direct ventilation cavity 300. The direct ventilation fan 330 accelerates the airflow in the direct ventilation cavity 300, facilitates dissipation of the heat in the direct ventilation cavity 300, and enhances the heat exchange ability of the electronic cavity 500.

In the cabinet 1000 according to some embodiments of the present disclosure, at least one circulating fan 900 is provided in the electronic cavity 500. The at least one circulating fan 900 is configured to drive an airflow in the electronic cavity 500 to flow. As shown in FIG. 2 and FIG. 4, the airflow in the electronic cavity 500 circulates in a clockwise direction. Of course, in some embodiments not shown in the drawings, the airflow in the electronic cavity 500 may alternatively flow in a counterclockwise direction. The circulating fan 900 is disposed in the electronic cavity 500 for accelerating the airflow in the electronic cavity. The heat flows from the electronic cavity 500 to the direct ventilation duct 400. At this time, there is a temperature difference between the electronic cavity 500 and the direct ventilation duct 400, and the heat is transferred from the electronic cavity 500 to a side wall between the electronic cavity 500 and the direct ventilation duct 400, to complete heat transfer between the electronic cavity 500 and the direct ventilation duct 400. At this time, the circulating fan 900 accelerates the airflow in the electronic cavity 500, and also increases a contact frequency between the airflow in the electronic cavity 500 and the direct ventilation duct 400, thereby improving a frequency of heat exchange and the heat dissipation efficiency.

In some embodiments of the present disclosure, the direct ventilation cavity 300 passes through the electronic cavity 500, and a cavity wall of the direct ventilation cavity 300 is separated from a cavity wall of the electronic cavity 500, to form a circulating duct between the cavity wall of the direct ventilation cavity 300 and the cavity wall of the electronic cavity 500. The circulating duct surrounds the direct ventilation cavity 300, and the duct arrangement of the direct ventilation cavity 300 does not interfere with the electronic cavity 500.

In the cabinet 1000 according to some embodiments of the present disclosure, as shown in FIG. 1, the electronic cavity 500 includes a first electronic sub-chamber 510, a second electronic sub-chamber 520, and a connection chamber 530, the first electronic sub-chamber 510 being in communication with the second electronic sub-chamber 520 through the connection chamber 530. The first electronic sub-chamber 510 and the second electronic sub-chamber 520 are located at two sides of the direct ventilation cavity 300. The connection chamber 530 extends through the direct ventilation cavity 300. Two connection chambers 530 are provided. When the airflow in the electronic cavity 500 circulates in the clockwise direction, the airflow sequentially passes through the first electronic sub-chamber 510, an upper connection chamber 530, the second electronic sub-chamber 520, a lower connection chamber 530, and finally re-enters the first electronic sub-chamber 510 and continuously circulates to form a complete, closed, and enclosed path. In some embodiments not shown in the drawings, when the airflow in the electronic cavity 500 circulates in the counterclockwise direction, the airflow sequentially passes through the first electronic sub-chamber 510, the lower connection chamber 530, the second electronic sub-chamber 520, the upper connection chamber 530, and finally re-enters the first electronic sub-chamber 510 for continuous circulation. Through this design, the electronic cavity 500 is isolated from the outside world, which can ensure the circulation of the airflow of the electronic cavity 500 to facilitate subsequent heat exchange, and ensure a pollution-free operation environment of the electronic cavity 500. Therefore, some second components with relatively high requirements for dustproofing, waterproofing, etc. may be placed in the electronic cavity 500 to prevent the second components from being corroded or polluted, thereby improving the protection level of the entire cabinet 1000.

According to different requirements for protection levels of the components in the cabinet 1000, the components are classified and disposed in the enclosed electronic cavity 500 and the open direct ventilation cavity 300. The electronic cavity 500 performs internal circulation and exchanges heat with the outside world through the liquid-cooling heat exchanger 600, which not only ensures the protection level of the electronic cavity 500, but also realizes heat exchange. The direct ventilation cavity 300 is in communication with the outside world, and does not interfere with the internal circulation duct of the electronic cavity 500 in structure. The components stored according to classification reduce design requirements and cost of the liquid-cooling heat exchanger 600, and improve the overall heat exchange efficiency of the cabinet 1000.

In some embodiments not shown in the drawings, the electronic cavity 500 may further include a plurality of sub-cavities in communication with each other, to arrange different components in different sub-cavities to prevent mutual interference due to the small distance between different components.

In an embodiment, as shown in FIG. 2 and FIG. 4, the circulating fan 900 is provided in each of the first electronic sub-chamber 510 and the second electronic sub-chamber 520. The circulating fan 900 is configured to drive an airflow in the first electronic sub-chamber 510, the connection chamber 530, and the second electronic sub-chamber 520 to flow in a predetermined direction. The circulating fan 900 causes relative flow of the air in the electronic cavity 500, so that the airflow continuously flows through the first electronic sub-chamber 510 and exchanges heat with the liquid-cooling heat exchanger 600, then flows into the connection chamber 530 and performs secondary heat dissipation with the direct ventilation duct 400, then absorbs heat in the second electronic sub-chamber 520, and then performs third heat dissipation in the connection chamber 530 with the direct ventilation duct 400. This continuous circulation increases the heat exchange frequency of the electronic cavity 500.

In the cabinet 1000 according to some embodiments of the present disclosure, referring to FIG. 2 to FIG. 5, the liquid-cooling heat exchanger 600 has a first heat exchange channel 603 and a second heat exchange channel 604. The first heat exchange channel 603 is connected to the cooling fin 700 through the first pipeline 601, and the electronic cavity 500 is in communication with the second heat exchange channel 604 to exchange heat with the first heat exchange channel 603. The first heat exchange channel 603 and the second heat exchange channel 604 transfer heat through a wall surface of the heat exchanger. In an example, after the airflow in the electronic cavity 500 enters the second heat exchange channel 604, heat of the second heat exchange channel 604 is higher than heat of the first heat exchange channel 603. Since there is a temperature difference between the first heat exchange channel 603 and the second heat exchange channel 603, the heat is transferred to the first heat exchange channel 603 with a lower temperature through a wall surface between the second heat exchange channel 604 and the first heat exchange channel 603, transferred to the first pipeline 601 through the first heat exchange channel 603, and then transferred to the cooling fin 700 through the first pipeline 601. Finally, the heat absorbed by the cooling fin 700 is transferred to the outside of cabinet 1000 through the cold air in the end chamber 200, to complete the heat dissipation of cabinet 1000.

### First embodiment

A cabinet 1000 according to a first embodiment of the present disclosure is described below with reference to FIG. 1 and FIG. 2. The cabinet 1000 includes a cabinet body 100, a liquid-cooling heat exchanger 600, a cooling fin 700, a heat dissipation fan 800, and a circulating fan 900. The cabinet body 100 includes an end chamber 200, a direct ventilation cavity 300, and an electronic cavity 500. The end chamber 200 is formed above the cabinet body 100. The direct ventilation cavity 300 and the electronic cavity 500 are located below the end chamber 200. The direct ventilation cavity 300 is located at one side of the cabinet body 100, and the electronic cavity 500 is in a closed annular shape and is located at another side of the direct ventilation cavity 300. The cabinet body 100 has a heat dissipation air inlet 201 and a heat dissipation air outlet 202, Moreover, the heat dissipation air inlet 201 and the heat dissipation air outlet 202 are located at two sides of the end chamber 200, respectively. The cooling fin 700 and the heat dissipation fan 800 are provided in the end chamber 200. The heat dissipation fan 800 is a blowing fan.

Part of the direct ventilation duct 400 is formed in the direct ventilation cavity 300. Two ends of the direct ventilation duct 400 are in communication with outside of the cabinet body 100, respectively. Heat exchange is performed between the direct ventilation cavity 300 and the electronic cavity 500. The direct ventilation cavity 300 includes a power module 310. The power module 310 includes a liquid-cooling heat exchange unit 320. The liquid-cooling heat exchange unit 320 is connected to the cooling fin 700 through a second pipeline 602, and the second pipeline 602 contains a cooling liquid.

The liquid-cooling heat exchanger 600 is disposed in the electronic cavity 500. The liquid-cooling heat exchanger 600 includes a first pipeline 601, a first heat exchange channel 603, and a second heat exchange channel 604. The first pipeline 601 contains the cooling liquid. The first heat exchange channel 603 is connected to the cooling fin 700 through the first pipeline 601. The electronic cavity 500 is in communication with the second heat exchange channel 604, to exchange heat with the first heat exchange channel 603.

The electronic cavity 500 includes a first electronic sub-chamber 510, a second electronic sub-chamber 520, and two connection chambers 530. One of the two connection chambers 530 is located above the other connection chamber 530 and is in communication with the first electronic sub-chamber 510 and the second electronic sub-chamber 520, and the other connection chamber 530 located below is in communication with the second electronic sub-chamber 520 and the first electronic sub-chamber 510. Part of the electronic cavity 500 is in communication with the second heat exchange channel 604 in the liquid-cooling heat exchanger 600. Two circulating fans 900 are provided and are mounted in the first electronic sub-chamber 510 and the second electronic sub-chamber 520, respectively. A second component is provided in the electronic cavity 500.

### Second embodiment

A cabinet 1000 according to a fifth embodiment of the present disclosure is described below with reference to FIG. 6. The cabinet 1000 of this embodiment is substantially the same as the cabinet 1000 of the first embodiment, except that the end chamber 200 has a heat dissipation air inlet 201. The heat dissipation air inlet 201 is formed on the cabinet body 100. The end chamber 200 is in communication with the direct ventilation cavity 300 to form the direct ventilation duct 400. The heat dissipation air inlet 201 is configured to be in communication with the direct ventilation inlet 410 to form one air inlet, and the heat dissipation fan 800 is disposed in the end chamber 200.

### Third embodiment

A cabinet 1000 according to a third embodiment of the present disclosure is described below with reference to FIG. 3. The cabinet 1000 of this embodiment is substantially the same as the cabinet 1000 of the first embodiment, and also has the cabinet body 100, the liquid-cooling heat exchanger 600, and the cooling fin 700, but does not have the heat dissipation fan 800 and the circulating fan 900. An outer wall of the direct ventilation cavity 300 is provided with a direct ventilation inlet 410. A bottom of the direct ventilation cavity 300 is provided with a direct ventilation outlet 420. Moreover, the direct ventilation fan 330 is provided in the direct ventilation cavity 300.

### Fourth embodiment

A cabinet 1000 according to a fourth embodiment of the present disclosure is described below with reference to FIG. 4. The cabinet 1000 of this embodiment is substantially the same as the cabinet 1000 of the first embodiment, and also has the cabinet body 100, the liquid-cooling heat exchanger 600, the cooling fin 700, the heat dissipation fan 800, and the circulating fan 900, except that the heat dissipation fan 800 in the end chamber 200 is an exhaust fan.

### Fifth embodiment

A cabinet 1000 according to a fourth embodiment of the present disclosure is described below with reference to FIG. 5. The cabinet 1000 of this embodiment is substantially the same as the cabinet 1000 of the third embodiment, except that the ventilation air inlet 410 is in communication with the heat dissipation air inlet 201, the direct ventilation cavity 300 is provided with the direct ventilation fan 330, the end chamber 200 does not have a heat dissipation fan 800, and one circulating fan 900 is provided and mounted in the second electronic sub-chamber 520.

According to some embodiments of another aspect of the present disclosure, an energy storage converter is provided. The energy storage converter includes a cabinet 1000, a first component, and a second component. The cabinet 1000 is the cabinet 1000 in the above-described embodiments. The first component and the second component are disposed in the cabinet 1000. The first component is disposed in the direct ventilation cavity 300, and the second component is disposed in the electronic cavity 500. Since the direct ventilation cavity 300 is in communication with the outside world, some components with high heat productivity, such as a reactance unit and a power module 310, may be provided in the direct ventilation cavity 300 to be quickly cooled through the direct ventilation duct 400. Meanwhile, the liquid-cooling heat exchange unit 320 may be used to further reduce temperatures of the components. The second component is an electronic component. The electronic cavity 500 is closed, and the electronic components usually need to be protected emphatically. Therefore, these components are arranged in the closed electronic cavity 500, which provides a relatively stable and pollution-free operation environment for the electronic components, and solves a problem of negative influence of an external environment on the electronic components. From a perspective of protection performance of the cabinet 1000, the cabinet 1000 provided with the liquid-cooling heat exchanger 600 does not need to arrange an external air-cooling duct additionally. Compared with a design of conventional air-cooling heat exchange, a risk that the electronic cavity 500 is polluted due to air leakage of the air-cooling duct at the heat exchanger is fundamentally eliminated, and the protection performance of the cabinet 1000 is further improved.

An energy storage system is provided according to some embodiments of yet another aspect of the present disclosure includes an energy storage converter. It can be understood that the energy storage converter adopts a structure of the energy storage converter in the above-described embodiments, which is known to those skilled in the art, and therefore at least has the beneficial effects brought by the technical solutions of the above-described embodiments, and details are omitted herein.

A photovoltaic power generation system according to some embodiments of still yet another aspect of the present disclosure includes an energy storage system. The energy storage system is the energy storage system of the above-described embodiments.

In the description of the present disclosure, it should be understood that, orientation or position relationship indicated by terms such as "over", "below", "front", "back", "left", "right", "top", "bottom", "in", "out", etc., is based on the orientation or position relationship shown in the accompanying drawings, and is merely for the convenience of describing the present disclosure and simplifying the description, rather than indicating or implying that the associated device or element must have a specific orientation, or be constructed and operated in a specific orientation, and therefore cannot be understood as a limitation on the present disclosure.

In the present disclosure, unless specified or limited otherwise, the terms "mounted", "connected", "coupled", and "fixed" should be understood in a broad sense. For example, it may be a fixed connection or a detachable connection or connection as one piece; mechanical connection or electrical connection or intercommunication; direct connection or indirect connection through an intermediate; internal communication of two components or the interaction relationship between two components. For those skilled in the art, the specific meaning of the above-mentioned terms in the present disclosure can be understood according to specific circumstances.

In the description of this specification, descriptions with reference to the terms "some embodiments", "examples", "specific examples", or "some examples", etc. mean that specific features, structure, materials, or characteristics described in conjunction with the embodiment or example are included in at least one embodiment or example of the present disclosure. In this specification, the schematic representations of the above terms do not necessarily refer to the same embodiment or example. Moreover, the described specific features, structures, materials or characteristics may be combined in any one or more embodiments or examples in a suitable manner. In addition, those skilled in the art can combine the different embodiments or examples described in this specification.

Although the embodiments of the present disclosure have been shown and described above, it can be understood that the above-mentioned embodiments are exemplary and should not be construed as limiting the present disclosure, and changes, modifications, substitutions, and variations can be made by those skilled in the art to the embodiments without departing from the scope of the present disclosure.

## Claims

1. A cabinet (1000) for an energy storage converter, comprising:
a cabinet body (100) comprising an end chamber (200), a direct ventilation cavity (300), and an electronic cavity (500), the direct ventilation cavity (300) being independent from the electronic cavity (500), the electronic cavity (500) being independent from the end chamber (200), at least part of a direct ventilation duct (400) being formed in the direct ventilation cavity (300), and two ends of the direct ventilation duct (400) being in communication with outside of the cabinet body (100);
a liquid-cooling heat exchanger (600) disposed in the electronic cavity (500);
a cooling fin (700) disposed in the end chamber (200), the liquid-cooling heat exchanger (600) being connected to the cooling fin (700) through a first pipeline (601), and the first pipeline (601) containing a cooling liquid; and
a heat dissipation fan (800) configured to guide an external airflow to flow into the end chamber (200) and flow out of the cabinet body (100) after flowing through the cooling fin (700).

2. The cabinet (1000) for the energy storage converter according to claim 1, wherein the cabinet body (100) further comprises a power module (310) disposed in the direct ventilation cavity (300), the power module (310) comprising a liquid-cooling heat exchange unit (320), the liquid-cooling heat exchange unit (320) being connected to the cooling fin (700) through a second pipeline (602), and the second pipeline (602) containing a cooling liquid.

3. The cabinet (1000) for the energy storage converter according to claim 1, wherein the cabinet body (100) has a heat dissipation air inlet (201) and a heat dissipation air outlet (202), the end chamber (200) being in communication with the outside of the cabinet body (100) through the heat dissipation air inlet (201) and the heat dissipation air outlet (202), and the heat dissipation fan (800) being disposed in the end chamber (200).

4. The cabinet (1000) for the energy storage converter according to claim 1, wherein the cabinet body (100) has a heat dissipation air inlet (201) and a direct ventilation outlet (420), the end chamber (200) being in communication with the outside of the cabinet body (100) through the heat dissipation air inlet (201), the direct ventilation cavity (300) being in communication with the outside of the cabinet body (100) through the direct ventilation outlet (420), the end chamber (200) being in communication with the direct ventilation cavity (300) to form the direct ventilation duct (400), and the heat dissipation fan (800) being disposed in the end chamber (200) and/or the direct ventilation cavity (300).

5. The cabinet (1000) for the energy storage converter according to claim 1, wherein an outer wall of the direct ventilation cavity (300) has a direct ventilation inlet (410) and a direct ventilation outlet (420), the direct ventilation cavity (300) being in communication with the outside of the cabinet body (100) through each of the direct ventilation inlet (410) and the direct ventilation outlet (420), and at least one direct ventilation fan (330) being provided in the direct ventilation cavity (300).

6. The cabinet (1000) for the energy storage converter according to claim 1, wherein at least one circulating fan (900) is provided in the electronic cavity (500), the at least one circulating fan (900) being configured to drive an airflow in the electronic cavity (500) to flow.

7. The cabinet (1000) for the energy storage converter according to claim 1 or 6, wherein the electronic cavity (500) comprises a first electronic sub-chamber (510), a second electronic sub-chamber (520), and a connection chamber (530), the first electronic sub-chamber (510) being in in communication with the second electronic sub-chamber (520) through the connection chamber (530), the first electronic sub-chamber (510) and the second electronic sub-chamber (520) being located at two sides of the direct ventilation cavity (300), and the connection chamber (530) extending through the direct ventilation cavity (300).

8. The cabinet (1000) for the energy storage converter according to claim 7, wherein a circulating fan (900) is provided in each of the first electronic sub-chamber (510) and the second electronic sub-chamber (520), the circulating fan (900) being configured to drive an airflow in the first electronic sub-chamber (510), the connection chamber (530), and the second electronic sub-chamber (520) to flow in a predetermined direction.

9. The cabinet (1000) for the energy storage converter according to claim 1, wherein the liquid-cooling heat exchanger (600) has a first heat exchange channel (603) and a second heat exchange channel (604), the first heat exchange channel (603) being connected to the cooling fin (700) through the first pipeline (601), and the electronic cavity (500) being in communication with the second heat exchange channel (604) to exchange heat with the first heat exchange channel (603).

10. An energy storage converter, comprising:
the cabinet (1000) for the energy storage converter according to any one of claims 1 to 9;
a first component disposed in the direct ventilation cavity (300); and
a second component disposed in the electronic cavity (500).

11. An energy storage system, comprising the energy storage converter according to claim 10.

12. A photovoltaic power generation system, comprising the energy storage system according to claim 11.
